(19) Europäisches Patentamt / European Patent Office / Office européen des brevets

(11) **EP 2 232 610 B1**

(12) **FASCICULE DE BREVET EUROPÉEN**

(45) Date de publication et mention de la délivrance du brevet:
**24.05.2017 Bulletin 2017/21**

(21) Numéro de dépôt: **08866914.8**

(22) Date de dépôt: **23.12.2008**

(51) Int Cl.:
***H01L 51/52** (2006.01)*

(86) Numéro de dépôt international:
**PCT/FR2008/052412**

(87) Numéro de publication internationale:
**WO 2009/083693 (09.07.2009 Gazette 2009/28)**

(54) **DISPOSITIF ÉLECTROLUMINESCENT ORGANIQUE**

ORGANISCHES LICHTEMITTIERENDES ELEMENT

ORGANIC LIGHT EMITTING DEVICE

(84) Etats contractants désignés:
**AT BE BG CH CY CZ DE DK EE ES FI FR GB GR HR HU IE IS IT LI LT LU LV MC MT NL NO PL PT RO SE SI SK TR**

(30) Priorité: **27.12.2007 FR 0709146**

(43) Date de publication de la demande:
**29.09.2010 Bulletin 2010/39**

(73) Titulaire: **Saint-Gobain Glass France**
**92400 Courbevoie (FR)**

(72) Inventeurs:
• **LECAMP, Guillaume**
**F-75018 Paris (FR)**
• **VERMERSCH, François-Julien**
**F-75014 Paris (FR)**
• **TCHAKAROV, Svetoslav**
**F-94110 Arcueil (FR)**
• **GERARDIN, Hadia**
**F-75012 Paris (FR)**
• **GIASSI, Alessandro**
**F-75012 Paris (FR)**

(74) Mandataire: **Saint-Gobain Recherche**
**Département Propriété Industrielle**
**39 Quai Lucien Lefranc**
**93300 Aubervilliers (FR)**

(56) Documents cités:
| | |
|---|---|
| **EP-A- 1 329 307** | **EP-A- 1 403 939** |
| **WO-A-2006/013373** | **DE-A1- 19 733 053** |
| **FR-A- 2 844 136** | **JP-A- H1 170 610** |
| **JP-A- 2001 243 840** | **US-A1- 2003 049 464** |
| **US-A1- 2005 073 228** | **US-A1- 2005 264 185** |

## Description

La présente invention a pour objet un dispositif électroluminescent organique. Les systèmes électroluminescents organiques connus ou OLED (pour « Organic Light Emitting Diodes » en anglais) comportent un ou plusieurs matériaux électroluminescents organiques alimentés en électricité par des électrodes généralement sous forme de deux couches électroconductrices encadrant ce(s) matériau(x).

Ces couches électroconductrices comportent communément une couche à base d'oxyde d'indium, généralement l'oxyde d'indium dopé à l'étain plus connu sous l'abréviation ITO. Les couches ITO ont été particulièrement étudiées. Elles peuvent être aisément déposées par pulvérisation cathodique assistée par champ magnétique, soit à partir d'une cible d'oxyde (pulvérisation non réactive), soit à partir d'une cible à base d'indium et d'étain (pulvérisation réactive en présence d'un agent oxydant du type oxygène) et leur épaisseur est de l'ordre de 100 à 150 nm. Cependant, cette couche d'ITO présente un certain nombre d'inconvénients. En premier lieu, la matière et le procédé de dépôt à température élevée (350°C) pour améliorer la conductivité engendrent des surcoûts. La résistance par carré reste relativement élevée (de l'ordre de 10 Ω par carré) à moins d'augmenter l'épaisseur des couches au-delà de 150 nm ce qui résulte en une diminution de la transparence et en une augmentation de la rugosité de surface ce qui est critique pour les OLEDs.

En outre, pour un éclairage uniforme sur de grandes surfaces, il est nécessaire de former une électrode inférieure discontinue, typiquement en formant des zones d'électrodes de quelques mm$^2$ et de réduire drastiquement la distance entre chaque zone d'électrodes, typiquement de l'ordre d'une dizaine de microns. Et, pour ce faire, on fait notamment appel à des techniques de photolithographie et de passivation coûteuses et complexes.

Aussi, de nouvelles structures d'électrodes se développent utilisant une couche mince métallique à la place de l'ITO afin de fabriquer des dispositifs OLED émettant une lumière sensiblement blanche pour l'éclairage.

On connaît par exemple par le document US2005/0073228A1 un dispositif organique électroluminescent émettant une lumière sensiblement blanche, lequel est pourvu d'une électrode, communément appelée électrode inférieure ou arrière (ou « bottom electrode » en anglais), qui est constituée de l'empilement de couches suivants:

- une sous couche de réduction de l'absorption,
- une couche mince métallique semi-réfléchissante, comme par exemple une couche d'argent de 22,5 nm,
- une surcouche en matériau conducteur transparent tel que l'ITO.

L'électrode supérieure est, quant à elle, composée d'une couche mince métallique réfléchissante et opaque, comme par exemple une couche d'argent de 75,5 nm.

Ces deux couches métalliques forment une microcavité de type Fabry-Pérot induisant un spectre d'émission du dispositif OLED centré sur une longueur d'onde de résonance donnée.

Ce spectre d'émission étant fortement dépendant de l'angle d'observation, le dispositif OLED comporte en outre un élément optique apte à réduire cette dépendance angulaire en formant un seul spectre d'émission large bande dans le visible.

Cet élément optique se présente comme un système limitant les réflexions internes totales (« FTIR » en anglais), lequel est agencé sous l'électrode inférieure ou sur la face opposée du substrat. Il se présente par exemple sous forme d'une feuille en téflon.

Document US2005/0264185 décrit une électrode constituée d'un empilement de couches métalliques alternées avec des couches d'oxyde métallique. Une telle électrode est utilisée comme électrode supérieure d'une OLED.

EP1329307 décrit un empilement de couche pouvant être utilisé comme électrode transparente et comprenant des couches métalliques et des couches d'oxyde de zinc.

DE19733053 décrit une électrode transparente comprenant une alternance de couches d'argent et de couches d'ITO.

EP1403939 décrit un dispositif OLED polychromatique dans lequel des microcavités sont créées.

JP11070610 décrit une électrode transparente ayant une faible résistance de surface dans laquelle des couches d'oxyde comprenant de l'oxyde de zinc et des couches métalliques sont utilisées. Le but que se fixe l'invention est de fournir un dispositif OLED qui tout en limitant la dépendance angulaire du spectre d'émission polychromatique dans le visible soit de conception plus simple et/ou plus efficace.

Il s'agit de mettre au point en particulier un dispositif OLED convenant tout particulièrement dans des applications d'éclairage général (architectural et/ou décoratif), et/ou de rétroéclairage, et/ou de signalétique, et ce pour toute taille.

A cet effet, l'invention a pour objet un dispositif électroluminescent organique tel que décrit dans la revendication 1.

En outre, conformément à l'invention :

- L2 est comprise notamment entre 160 nm et 200 nm,
- la somme des épaisseurs e1+e2 des première et deuxième couches métalliques est de préférence inférieure ou égale à 25 nm pour réduire l'absorption.

- l'électrode inférieure présente une résistance par carré inférieure ou égale à 6 Ω/carré.

Ainsi le choix d'une structure d'électrode comportant au moins deux couches métalliques combiné aux choix judicieux des épaisseurs optiques L1 et L2 permet de réduire significativement la variation colorimétrique en fonction de l'angle d'observation.

Plus précisément, la présence de deux couches métalliques dans la première électrode (électrode inférieure, qui est l'électrode la plus proche du substrat) permet de créer, une fois le dispositif OLED complet, des microcavités résonantes (respectivement entre la première couche mince métallique et la deuxième électrode, entre la deuxième couche mince métallique et la deuxième électrode) à deux longueurs d'onde distinctes dans le visible et suffisamment espacées, (de préférence espacé d'au moins 100 nm, voire 200 nm), par exemple l'une à 450 nm et l'autre à 650 nm. En ajustant correctement la gamme de valeurs de L1 et de L2 conformément à l'invention (ce qui revient à ajuster les distances optiques des deux microcavités), on élargit ces deux pics pour former un unique spectre large bande dans le visible.

Le spectre visé peut être indifféremment un spectre sensiblement « plat » dans le visible, produisant une lumière blanche (quasi) pure, ou tout autre spectre notamment ceux répondant aux spécifications dans les domaines du rétro-éclairage et de l'éclairage : spectre de l'illuminant A (lumière « jaune ») défini à 0° par des coordonnées (0,45 ; 0,41) dans le diagramme colorimétrique CIE XYZ 1931, spectre de l'illuminant E (lumière « blanche ») défini à 0° par des coordonnées (0,33 ; 0,33) dans le diagramme colorimétrique CIE XYZ 1931 etc.

De préférence, pour avoir un rendu colorimétrique optimal, les résonances obtenues par les choix de L1 et L2 n'atténuent pas fortement par des effets interférentiels une ou des couleurs du spectre d'émission des couches émettrices du système OLED. Par exemple, l'atténuation peut être inférieure à 70% voire inférieure ou égale à 50%.

De manière avantageuse, pour limiter au mieux la dépendance angulaire :

- L1 est inférieure ou égale à 100 nm, encore plus préférentiellement inférieure ou égale à 80 nm, et/ou
- L1 est supérieure ou égale à 40 nm, encore plus préférentiellement supérieure ou égale à 50 nm, et/ou
- L2 est inférieure ou égale à 160 nm, voire à 130 nm, et/ou
- et/ou L2 est supérieure ou égale à 90 nm, et/ou
- L1 est inférieure à L2, notamment L1 est au moins supérieure ou égale à 1,5L1 voire à 1,65L1 et de préférence inférieure à 2,5L1 voire inférieure à 2L1.

L'électrode n'est pas optimisée pour être la plus transparente possible mais afin de réaliser les microcavités adaptées aux émetteurs large bande.

Par ailleurs, de façon surprenante, l'ajout d'une deuxième couche d'argent pénalise peu l'efficacité d'extraction dans l'air du rayonnement optique émis par le dispositif OLED, c'est à dire la proportion de puissance optique sortant dans l'air par rapport à la puissance optique totale émise par la source.

Le dispositif OLED muni d'une telle électrode est simple, compact fiable, robuste et n'est pas tributaire d'un élément fonctionnel additionnel comme dans la solution décrite dans le document US2005/0073228A1. On peut toutefois augmenter encore l'extraction de lumière du dispositif OLED selon l'invention en rajoutant cet élément fonctionnel décrit dans le document US2005/0073228A1 (couche diffusante en volume ou en surface, feuille de téflon etc).

L'électrode selon l'invention peut s'étendre sur une grande surface par exemple une surface supérieure ou égale à 0,02 m$^2$ voire même supérieure ou égale à 0,5 m$^2$ ou supérieure ou égale à 1 m$^2$.

L'électrode selon l'invention conserve des propriétés d'électroconductivité satisfaisantes voire même améliorer lorsque la première couche séparatrice n'est pas isolante.

Par « couche » au sens de la présente invention, il faut comprendre qu'il peut y avoir une couche en un matériau unique (monocouche) ou plusieurs couches (multicouche), chacune en un matériau différent.

Au sens de la présente invention, en l'absence de toute indication, l'épaisseur correspond à l'épaisseur géométrique.

Au sens de la présente invention, l'expression « à base de » s'entend d'une manière habituelle d'une couche contenant majoritairement le matériau en jeu, c'est-à-dire contenant au moins 50 % de ce matériau en masse.

Au sens de la présente invention, l'expression « est compris(e) entre » comprend naturellement les valeurs limites indiquées.

Dans la présente invention, on parle d'une couche sous jacente « x », ou d'une couche « x » sous une autre couche « y », cela implique naturellement que la couche « x » est plus proche du substrat que la couche « y ».

Pour les indices optiques n0, n1 on peut choisir la valeur à 550 nm.

La sous couche antireflet (comme la première couche séparatrice) pouvant être multicouche, l'épaisseur optique L1 (ou L2) est naturellement la somme des épaisseurs optiques de chaque couche en jeu, et l'indice optique n1 est l'indice de la multicouche. On effectue donc la somme pour toutes les couches du produit épaisseur de couche par l'indice optique de couche.

Naturellement, la sous couche antireflet (couche de fond éventuelle et/ou couche de lissage éventuelle, et/ou couche de contact) et la première couche séparatrice (couche additionnelle éventuelle et/ou couche de lissage éventuelle et/ou couche de contact) sont préférentiellement (essentiellement) diélectriques (c'est-à-dire non métalliques).

Naturellement, la sous couche antireflet, la première couche séparatrice et la surcouche sont préférentiellement composées de couches minces.

De préférence, la première et/ou la deuxième couche métallique peut être :

- à base d'un matériau pur choisi, en premier choix, parmi l'argent, l'or, l'aluminium, le cuivre, ou en deuxième choix, parmi d'autres métaux moins conducteurs tels que le molybdène,
- ou à base d'un des matériaux précités allié ou dopé avec au moins un autre matériau choisi parmi : Ag, Au, Pd, Al, Pt, Cu, Zn, Cd, In, Si, Zr, Mo, Ni, Cr, Mg, Mn, Co, Sn, notamment est à base d'un alliage argent et de palladium et/ou d'or et/ou de cuivre, pour améliorer la résistance à l'humidité de l'argent.

La première couche métallique peut en particulier en molybdène notamment lorsqu'elle ne contribue pas à la conductivité électrique de l'électrode.

Les première et deuxième couches métalliques peuvent être en un même matériau.

Dans une conception préférée, les première et deuxième couches métalliques sont à base d'argent (c'est-à-dire en argent pur ou en alliage métallique contenant majoritairement de l'argent) et éventuellement :

- l'épaisseur e1 est inférieure ou égale à 15 nm, notamment comprise entre 6 et 15 nm, voire inférieure ou égale à 13 nm, et/ou inférieure ou égale à 13 nm, et/ou
- l'épaisseur e2 est inférieure ou égale à 15 nm, notamment comprise entre 6 et 15 nm, voire inférieure ou égale à 7 nm, et/ou supérieure ou égale à 10 nm, et/ou
- l'épaisseur e1 est supérieure à l'épaisseur e2 (de 1 à quelques nanomètres).

Naturellement, la première et/ou la deuxième couche métallique peut être une multicouche métallique.

Avantageusement, l'électrode inférieure selon l'invention peut présenter :

- une résistance par carré inférieure ou égale à 3 $\Omega$/carré notamment pour une épaisseur de deuxième couche métallique (fonctionnelle) à partir de 6 nm et éventuellement une épaisseur de première couche métallique, choisi également fonctionnelle à partir de 6 nm,
- et/ou une transmission lumineuse $T_L$ supérieure ou égale à 50% et de préférence comprise entre 60% et 90%, voire plus si cela ne nuit pas aux performances de l'OLED.

Naturellement, l'électrode peut comprendre une séquence de couches répétée éventuellement une à plusieurs fois, entre la deuxième couche métallique et la surcouche, la séquence étant formée :

- d'une autre couche séparatrice, en matériau tel que ceux listés pour la première couche séparatrice, éventuellement en le même matériau que la première couche séparatrice et/ ou d'épaisseur optique dans la gamme donnée pour la première couche séparatrice, et de préférence conductrice,
- surmontée (directement ou non) d'une autre couche métallique, en matériau tel que ceux listés pour les couches métalliques, éventuellement en le même matériau que la deuxième couche métallique, notamment à base d'argent.

On peut préférer alors que la somme des épaisseurs des couches métalliques soit inférieure ou égale à 40 nm.

La sous couche antireflet peut comprendre une ou plusieurs couches ne perturbant pas la fonction antireflet, notamment lorsque cette couche ou ces couches présentent chacune une faible épaisseur, typiquement inférieure à 10 nm, et par exemple un indice optique proche de celui du substrat.

De préférence, la sous couche antireflet peut présenter l'une au moins des caractéristiques suivantes :

- elle peut être de préférence directement déposée sur le substrat, et/ou

- être monocouche, bicouche, tricouche,
  et/ou
- elle présente un indice optique n1 supérieur à égal à 1,8, voire à 2, en particulier pour un substrat d'indice optique autour de 1,5,ou haut indice
  et/ou
- et/ou la majorité voire l'ensemble des couches formant la sous couche antireflet (voire l'ensemble des couches entre le substrat et la première couche métallique) présente un indice optique n1 supérieur à égal à 1,8, voire à 2,
  et/ou
- l'ensemble des couches entre le substrat et la première couche métallique présente une épaisseur optique inférieure ou égale à 120 nm,
  et/ou
- elle comprend une couche de fond, c'est-à-dire une couche la plus proche du substrat, couvrant de préférence sensiblement ladite face principale du substrat, et formant de préférence une barrière aux alcalins (si nécessaire) et/ou une couche d'arrêt de gravure(s) (sèche et/ou humide) et/ou une couche de lissage.

A titre d'exemple de couche de fond, on peut citer une couche d'oxyde de titane ou d'oxyde d'étain.

Une couche de fond formant une barrière aux alcalins (si nécessaire) et/ou une couche d'arrêt de gravure(s) peut être préférentiellement:

- à base d'oxycarbure de silicium (de formule générale SiOC),
- à base de nitrure de silicium (de formule générale $Si_xN_y$), tout particulièrement à base de $Si_3N_4$,
- à base d'oxynitrure de silicium (de formule générale $Si_xO_yN_z$),
- à base d'oxycarbonitrure de silicium (de formule générale $Si_xO_yN_zC_w$).
- voire à base d'oxyde de silicium (de formule générale $Si_xO_y$), pour des épaisseurs inférieure à 10 nm,

On peut choisir également d'autres oxydes et/ou nitrures et notamment :

- de l'oxyde de niobium ($Nb_2O_5$),
- de l'oxyde de zirconium ($ZrO_2$),
- de l'oxyde de titane ($TiO_2$),
- de l'alumine ($Al_2O_3$),
- de l'oxyde de tantale ($Ta_2O_5$),
- ou encore des nitrures d'aluminium, de gallium, de silicium et leurs mélanges, éventuellement dopé Zr.

Il est possible que la nitruration de la couche de fond soit légèrement sous stoechiométrique.

La couche de fond peut être ainsi une barrière aux alcalins sous jacents à l'électrode. Elle protège de toute pollution la ou les éventuelles couches sus-jacentes, notamment une couche de contact sous la première couche métallique (pollutions qui peuvent entraîner des défauts mécaniques tels que des délaminations) ; elle préserve en outre la conductivité électrique de la première couche métallique. Elle évite aussi que la structure organique d'un dispositif OLED ne soit polluée par les alcalins, réduisant de fait considérablement la durée de vie de l'OLED.

La migration des alcalins peut intervenir pendant la fabrication du dispositif, engendrant un manque de fiabilité, et/ou postérieurement, réduisant sa durée de vie.

La couche de fond peut améliorer les propriétés d'accrochage de la couche de contact sans accroître notablement la rugosité de l'ensemble de l'empilement de couches, même en cas d'interposition d'une ou de plusieurs couche entre la couche de fond et la couche de contact (couche de lissage etc).

La couche de fond est éventuellement dopée notamment pour augmenter son indice. La couche de fond peut présenter de préférence une épaisseur supérieure ou égale à 3 nm, voire à 5 nm.

Pour obtenir une épaisseur optique L1 souhaitée, on peut choisir une sous couche antireflet dont au moins la moitié, voire 60% ou plus, de son épaisseur géométrique est constituée de la couche de fond. Il peut s'agir notamment

- d'une couche de $Si_xN_y$ ($Si_3N_4$ notamment), seule ou dans un empilement de fond,
- de $SnO_2$ seule ou dans un empilement de fond, type $Si_xN_y$/ $SnO_2$,
- voire de $TiO_2$, seule ou dans un empilement de fond, de type $Si_xN_y$/$SnO_2$, $TiO_2$ étant éventuellement limité en épaisseur de par son indice optique élevé.

La sous couche antireflet peut comprendre de manière préférentielle une couche d'arrêt de gravure, notamment une couche à base d'oxyde d'étain.

Tout particulièrement, par souci de simplicité, la couche d'arrêt de gravure peut faire partie ou être la couche de fond : elle peut être de préférence être à base de nitrure de silicium ou elle peut être une couche qui est à base d'oxyde de silicium ou à base d'oxynitrure de silicium ou à base d'oxycarbure de silicium ou encore à base d'oxycarbonitrure de silicium et avec de l'étain pour renforcer par propriété d'anti gravure, couche de formule générale SnSiOCN.

La couche d'arrêt de gravure sert à protéger le substrat dans le cas d'une gravure chimique ou une gravure par plasma réactif.

Grâce à la couche d'arrêt de gravure, la couche de fond reste présente même dans des zones gravées (« patterned » en anglais). Aussi, la migration des alcalins, par effet de bord, entre le substrat dans une zone gravée et une partie d'électrode adjacente (voire une structure organique) peut être stoppée.

On peut préférer tout particulièrement une couche de fond / arrêt de gravure (essentiellement) en nitrure de silicium $Si_3N_4$, dopé ou non. Le nitrure de silicium est très rapide à déposer et forme une excellente barrière aux alcalins.

La première couche métallique, notamment à base d'argent, peut être de préférence déposée sous une forme cristallisée sur une couche mince diélectrique (non métallique), dite première couche de contact, qui est également de préférence cristallisée.

Alternativement ou cumulativement, la deuxième couche métallique, notamment à base d'argent peut être de préférence déposée sous une forme cristallisée sur une couche mince diélectrique (non métallique), dite deuxième couche de contact, qui est également de préférence cristallisée.

Une couche de contact favorise l'orientation cristalline adéquate de la couche métallique déposée dessus.

La première et la deuxième couche de contact sont à base d'oxyde de zinc éventuellement sous stoechiométrique et/ou éventuellement dopé. Le dopage s'entend d'une manière habituelle comme exposant une présence de l'élément dans une quantité inférieure à 10 % en masse d'élément métallique dans la couche et; l'expression « à base de » couvre ainsi le dopage. L'oxyde métallique peut être dopé notamment entre 0,5 et 5 % avec pour exemple un oxyde d'étain dopé par F ou S.

On peut choisir en particulier comme première couche de contact IZO (à base d'indium et de zinc), IGZO (à base d'indium, de gallium et de zinc) voire $Sn_xZn_yO_z$.

On peut choisir en particulier comme deuxième couche de contact IZO, IGZO voire $Sn_xZn_yO_z$.

La première et /ou la deuxième couche de contact peuvent être de préférence à base d'oxyde de zinc dopé par Al (AZO), Ga (GZO), voire par B, Sc, ou Sb pour une meilleure stabilité de procédé de dépôt. On préfère en outre une couche d'oxyde de zinc $ZnO_x$, avec préférentiellement x inférieur à 1, encore plus préférentiellement compris entre de 0,88 à 0,98, notamment de 0,90 à 0,95.

La première et /ou la deuxième couche de contact peut être, selon un exemple non conforme à la présente invention, à base de nitrure métallique notamment $Si_3N_4$ voire AlN, ou encore GaN, InN (plus onéreuses généralement). La première couche de contact peut alors se confondre avec la couche de fond, en particulier lorsque la couche de fond est à base de nitrure de silicium.

Par ailleurs, pour favoriser l'injection de courant et/ou limiter la valeur de la tension de fonctionnement, on peut prévoir de préférence que :

- la première couche séparatrice est constituée de couche(s) (hors fine couche de blocage décrite ultérieurement) de résistivité électrique (à l'état massif, telle que connue dans la littérature) inférieure ou égale à $10^7$ ohm.cm, de préférence inférieure ou égale à $10^6$ ohm.cm, voire même inférieure ou égale $10^4$ ohm.cm,
- et/ou la sous couche antireflet (et/ou la surcouche) est constituée de couche(s) (hors fine couche de blocage décrite ultérieurement) de résistivité électrique (à l'état massif, telle que connue dans la littérature) inférieure ou égale à $10^7$ ohm.cm, de préférence inférieure ou égale à $10^6$ ohm.cm, voire même inférieure ou égale $10^4$ ohm.cm.

On peut ainsi par exemple exclure une ou des couches (à tout le moins d'épaisseur (totale) supérieure ou égale à 15 nm voire supérieure ou égale 10 nm même 5 nm) à base de nitrure de silicium, d'oxyde de silicium, d'oxynitrure de silicium, d'oxycarbure de silicium, à base d'oxycarbonitrure de silicium, ou encore à base d'oxyde de titane.

Les première et/ou deuxième couche métalliques peuvent être de préférence, déposées directement sur leur couche de contact (sans tenir compte de la ou les couches de sous blocage décrites ultérieurement).

Naturellement, par souci de simplification, les première et deuxième couches de contact peuvent être en le même matériau.

L'épaisseur de la première et/ou de la deuxième couche de contact est de préférence supérieure ou égale à 3 nm voire supérieure ou égale à 5 nm et peut en outre être inférieure ou égale à 20 nm voire à 10 nm.

En cas de séquence(s) rajoutée (électrode à tri-couche métallique ou plus) comme déjà décrit, la ou chaque couche métallique rajoutée peut être sur une couche de contact en un ou les matériaux précités pour les couches de contact.

Le substrat selon l'invention revêtu de l'électrode inférieure présente, de préférence, une faible rugosité de telle sorte que l'écart de l'endroit le plus creux à l'endroit le plus haut (« peak to valley » en anglais) sur la surcouche soit inférieur ou égal à 10 nm.

Le substrat selon l'invention revêtu de l'électrode inférieure présente, de préférence, sur la surcouche une rugosité RMS inférieure ou égale à 10 nm, voire à 5 ou 3 nm, de préférence même inférieure ou égale à 2 nm, à 1,5 nm voire inférieure ou encore égale à 1 nm, afin d'éviter les défauts de pointes (« spike effect » en anglais) qui réduisent drastiquement la durée de vie et la fiabilité notamment de l'OLED.

La rugosité RMS signifie rugosité « Root Mean Square ». Il s'agit d'une mesure consistant à mesurer la valeur de l'écart quadratique moyen de la rugosité. Cette rugosité RMS, concrètement, quantifie donc en moyenne la hauteur des pics et creux de rugosité, par rapport à la hauteur moyenne. Ainsi, une rugosité RMS de 2 nm signifie une amplitude moyenne de pic double.

Elle peut être mesurée de différentes manières : par exemple, par microscopie à force atomique, par un système mécanique à pointe (utilisant par exemple les instruments de mesure commercialisés par la société VEECO sous la dénomination DEKTAK), par interférométrie optique La mesure se fait généralement sur un micromètre carré par microscopie à force atomique, et sur une surface plus importante, de l'ordre de 50 micromètres$^2$ à 2 millimètres$^2$ pour les systèmes mécaniques à pointe.

Cette faible rugosité est en particulier atteinte lorsque le substrat comporte une première couche de lissage, notamment non cristallisée, ladite première couche de lissage étant disposée immédiatement sous la première couche de contact et étant en un autre matériau que celui de la couche de contact.

La première couche de lissage est, de préférence, une couche d'oxyde simple ou mixte, dopée ou non, à base d'oxyde d'un ou de plusieurs des métaux suivants : Sn, Si, Ti, Zr, Hf, Zn, Ga, In notamment est une couche d'oxyde mixte à base de zinc et d'étain éventuellement dopée ou une couche d'oxyde mixte d'indium et d'étain (ITO) ou une couche d'oxyde mixte d'indium et de zinc (IZO).

La première couche de lissage peut être en particulier à base d'un oxyde mixte de zinc et d'étain $Sn_xZn_yO_z$ notamment non stoechiométrique et sous phase amorphe, éventuellement dopé, notamment à l'antimoine, ou d'un oxyde mixte d'indium et d'étain (ITO) notamment déposé à froid, ou d'un oxyde mixte d'indium et de zinc (IZO).

Cette première couche de lissage peut être de préférence sur la couche de fond ou encore directement sur le substrat.

On peut utiliser également une deuxième couche de lissage directement sous la deuxième couche de contact et en les matériaux déjà listés pour la première couche de lissage.

Naturellement, par souci de simplification, les première et deuxième couches de lissage peuvent être en le même matériau.

Plus largement, on peut utiliser une couche en $Sn_xZn_yO_z$, dopé ou non, éventuellement non stoechiométrique en oxygène, directement sous la première couche métallique (hors sous bloqueur éventuel) et/ou une couche en $Sn_xZn_yO_z$ dopé ou non, directement sous la deuxième couche métallique (hors sous bloqueur éventuel).

La première couche séparatrice peut comprendre sous la deuxième couche de contact et sous l'éventuelle deuxième couche de lissage, une première couche additionnelle d'oxyde métallique éventuellement dopé tel que l'oxyde de zinc (dopé à l'aluminium par exemple), l'oxyde d'étain, et/ou une deuxième couche additionnelle à base de nitrure de silicium

De préférence la couche additionnelle est en le matériau de la deuxième couche de contact, notamment à base de ZnO.

On a remarqué qu'une couche additionnelle à base de ZnO (avec ou sans surbloqueur comme détaillé plus tard), voire d'ITO, était particulièrement compatible avec la couche d'argent.

L'épaisseur de la couche additionnelle (tout comme l'épaisseur de la première et/ou de la deuxième couche de contact) est de préférence supérieure ou égale à 3 nm voire supérieure ou égale à 5 nm et peut en outre être inférieure ou égale à 20 nm voire à 10 nm.

Pour obtenir une épaisseur optique L2 souhaitée, on peut limiter les épaisseurs de l'éventuelle couche additionnelle et/ou de la deuxième couche de contact comme indiqué et/ou on peut choisir une première couche séparatrice dont au moins la moitié, voire 60%, 70%, 75% plus, de son épaisseur géométrique est constituée de la couche de lissage (formant éventuellement couche de contact), notamment de $Sn_xZn_yO_z$ seul, de $Si_xN_y$ seul ou combiné avec $Sn_xZn_yO_z$ ou $SnO_2$ sus jacent. On prévoit par exemple (sous une éventuelle couche de contact notamment à base de ZnO) : $Si_3N_4/Sn_xZn_yO_z$, $Si_3N_4/SnO_2 Sn_xZn_yO_z$ seule.

Pour obtenir une épaisseur optique L1 souhaitée, on peut limiter les épaisseurs de la première couche de contact comme indiqué et/ou on peut choisir une sous couche dont au moins la moitié, voire 60%, 80% ou plus, de son épaisseur géométrique est constituée de la couche de fond et/ou de préférence de la première couche de lissage (formant éventuellement couche de fond), notamment des couches de $Si_xN_y$, $SnO_2$, $TiO_2$ seules ou empilées, et/ou de la couche de lissage $Sn_xZn_yO_z$ de préférence directement sur le substrat. On prévoit par exemple : $Si_3N_4/Sn_xZn_yO_z$, $SnO_2/ Sn_xZn_yO_z$, $SnO_2 /TiO_2$, $TiO_2/ Sn_xZn_yO_z$, $Sn_xZn_yO_z$ seule,

En cas de séquence(s) rajoutée (électrode à tri-couche métallique ou plus) comme déjà décrit, la ou chaque couche séparatrice rajoutée peut comprendre une couche de lissage et/ou une couche de contact en les matériaux précités avec des éventuelles sur et/ou sous bloqueurs.

La surcouche d'adaptation du travail de sortie a un travail de sortie Ws à partir de 4,5 eV et de préférence supérieur ou égal à 5 eV.

La surcouche selon l'invention est, de préférence, à base d'un oxyde simple ou mixte, à base de l'un au moins des oxydes métalliques suivants, éventuellement dopé(s) : oxyde d'étain, oxyde d'indium, oxyde de zinc éventuellement sous stoechiométrique, oxyde d'aluminium, oxyde de chrome, oxyde de titane, oxyde de molybdène, oxyde de zirconium, oxyde d'antimoine, oxyde de tantale, oxyde de silicium, oxyde de niobium.

Cette surcouche peut en particulier être en oxyde d'étain éventuellement dopé par F, Sb, ou en oxyde de zinc éventuellement dopé à l'aluminium, ou être éventuellement à base d'un oxyde mixte notamment un oxyde mixte d'indium et d'étain (ITO), un oxyde mixte d'indium et de zinc (IZO), oxyde mixte de zinc et d'étain $Sn_xZn_yO_z$.

Cette surcouche peut présenter de préférence une épaisseur e3 inférieure ou égale à 40 nm, notamment inférieure ou égale à 30 nm, par exemple comprise entre 15 et 30 nm.

La surcouche selon l'invention peut être, alternativement, une couche mince métallique, notamment à base de nickel, platine ou palladium, par exemple d'épaisseur inférieure ou égale à 5 nm, notamment de 1 à 2 nm, et séparée de la deuxième couche métallique par une couche sous jacente, dite espaceur, en oxyde métallique simple ou mixte, tels que ceux précités pour la surcouche ou les couches de lissage ou de contact.

L'électrode inférieure selon l'invention est facile à fabriquer en particulier en choisissant pour les matériaux de l'empilement des matériaux qui peuvent être déposées à température ambiante, et ne nécessitant pas de recuit thermique pour obtenir une conductivité électrique correcte comme l'ITO. Encore plus préférentiellement la plupart voire toutes les couches de l'empilement sont déposées sous vide (de préférence successivement) de préférence par pulvérisation cathodique éventuellement assistée par magnétron, permettant des gains de productivité significatif.

Pour réduire encore le coût de l'électrode inférieure, on peut préférer que l'épaisseur totale en matériau contenant (de préférence majoritairement, c'est-à-dire avec un pourcentage massique en indium supérieur ou égal à 50%) de l'indium de cette électrode soit inférieure ou égale à 60 nm, voire inférieure ou égale à 50 nm, 40 nm, voire à 30 nm. On peut citer par exemple ITO, IZO comme couche(s) dont il est préférable de limiter les épaisseurs.

De préférence :

- la sous couche antireflet est une bicouche (hors fine couche de blocage), notamment constituée d'une couche de lissage et d'une couche de contact, en oxydes métalliques,
- et/ou la première couche séparatrice (hors fine(s) couche(s) de blocage)est une bicouche, en oxydes métalliques, avec une couche de lissage et une couche de contact, ou est une tricouche, en oxydes métalliques, avec comme première couche une couche additionnelle.

Peuvent aussi être prévus un, voire deux, revêtement(s) très fin(s) appelé(s) « revêtement de blocage », disposé(s) directement sous, sur ou de chaque côté de la première et/ou de la deuxième couche métallique notamment lorsque ces couches sont à base d'argent.

Le revêtement de sousblocage sous-jacent à une couche métallique (la première et/ou la deuxième), en direction du substrat, est un revêtement d'accrochage, de nucléation et/ou de protection.

Le revêtement de surblocage sus-jacent à une couche métallique (la première et/ou la deuxième) sert de revêtement de protection ou « sacrificiel » afin d'éviter l'altération de la couche métallique par attaque et/ou migration d'oxygène d'une couche qui le surmonte, voire aussi par migration d'oxygène si la couche qui le surmonte est déposée par pulvérisation cathodique en présence d'oxygène.

La couche métallique (la première et/ou la deuxième) peut ainsi être disposée directement sur au moins un revêtement de blocage sous-jacent et/ou directement sous au moins un revêtement de blocage sus-jacent, chaque revêtement présentant une épaisseur comprise de préférence entre 0,5 et 5 nm.

Au sens de la présente invention lorsqu'il est précisé qu'un dépôt de couche ou de revêtement (comportant une ou plusieurs couches) est effectué directement sous ou directement sur un autre dépôt, c'est qu'il ne peut y avoir interposition d'aucune couche entre ces deux dépôts.

Au moins un revêtement de blocage comprend, de préférence, une couche métallique, nitrure et/ou oxyde métallique, à base d'au moins l'un des métaux suivants : Ti, V, Mn, Fe, Co, Cu, Zn, Zr, Hf, Al, Nb, Ni, Cr, Mo, Ta, W, ou à base d'un alliage d'au moins un desdits matériaux, de préférence à base de Ni, ou Ti, à base d'un alliage de Ni, à base d'un alliage de NiCr.

Par exemple, un revêtement de blocage peut être constitué d'une couche à base de niobium, tantale, titane, chrome ou nickel ou d'un alliage à partir d'au moins deux desdits métaux, comme un alliage de nickel-chrome.

Une fine couche de blocage forme une couche de protection voire même une couche « sacrificielle » qui permet d'éviter l'altération du métal de la couche métallique (la première et/ou la deuxième), notamment dans l'une et/ou l'autre des configurations suivantes :

- si la couche qui surmonte la couche métallique (la première et/ou la deuxième) est déposée en utilisant un plasma réactif (oxygène, azote ...), par exemple si la couche d'oxyde qui la surmonte est déposée par pulvérisation cathodique,

- si la composition de la couche qui surmonte la couche métallique (la première et/ou la deuxième) est susceptible de varier lors de la fabrication industrielle (évolution des conditions de dépôt type usure d'une cible etc.) notamment si la stoechiométrie d'une couche de type oxyde et/ou nitrure évolue, modifiant alors la qualité de la couche métallique et donc les propriétés de l'électrode (résistance carré, transmission lumineuse, ...),
- si le revêtement électrode subit postérieurement au dépôt un traitement thermique.

Cette couche protectrice voire sacrificielle améliore significativement la reproductibilité des propriétés électriques et optiques de l'électrode. Cela est très important pour une démarche industrielle où seule une faible dispersion des propriétés des électrodes est acceptable.

On préfère en particulier une fine couche de blocage à base d'un métal choisi parmi le niobium Nb, le tantale Ta, le titane Ti, le chrome Cr ou le nickel Ni ou d'un alliage à partir d'au moins deux de ces métaux, notamment d'un alliage de niobium et de tantale (Nb/Ta), de niobium et de chrome (Nb/Cr) ou de tantale et de chrome (Ta/Cr) ou de nickel et de chrome (Ni/Cr). Ce type de couche à base d'au moins un métal présente un effet de piégeage (effet « getter ») particulièrement important.

Une fine couche de blocage métallique peut être aisément fabriquée sans altérer la couche métallique (la première et/ou la deuxième). Cette couche métallique peut être de préférence déposée dans une atmosphère inerte (c'est-à-dire sans introduction volontaire d'oxygène ou d'azote) constituée de gaz noble (He, Ne, Xe, Ar, Kr). Il n'est pas exclu ni gênant qu'en surface cette couche métallique soit oxydée lors du dépôt ultérieur d'une couche à base d'oxyde métallique.

La fine couche de blocage métallique permet en outre d'obtenir une excellente tenue mécanique (résistance à l'abrasion, aux rayures notamment).

Néanmoins, pour l'utilisation de couche de blocage métallique, il faut limiter l'épaisseur de la couche métallique et donc l'absorption lumineuse pour conserver une transmission lumineuse suffisante pour les électrodes transparentes.

La fine couche de blocage peut être partiellement oxydée. Cette couche est déposée sous forme non métallique et n'est donc pas déposée sous forme stoechiométrique, mais sous forme sous-stoechiométhque, du type $MO_x$, où M représente le matériau et x est un nombre inférieur à la stoechiométrie de l'oxyde du matériau ou du type $MNO_x$ pour un oxyde de deux matériaux M et N (ou plus). On peut citer par exemple $TiO_x$, $NiCrO_x$.

x est de préférence compris entre 0,75 fois et 0,99 fois la stoechiométrie normale de l'oxyde. Pour un monoxyde, on peut notamment choisir x entre 0,5 et 0,98 et pour un dioxyde x entre 1,5 et 1,98.

Dans une variante particulière, la fine couche de blocage est à base de $TiO_x$ et x peut être en particulier tel que $1,5 \leq x \leq 1,98$ ou $1,5 < x < 1,7$, voire $1,7 \leq x \leq 1,95$.

La fine couche de blocage peut être partiellement nitrurée. Elle n'est donc pas déposée sous forme stoechiométrique, mais sous forme sous-stoechiométrique, du type $MN_y$, où M représente le matériau et y est un nombre inférieur à la stoechiométrie de du nitrure du matériau. y est de préférence compris entre 0,75 fois et 0,99 fois la stoechiométrie normale du nitrure.

De la même manière, la fine couche de blocage peut aussi être partiellement oxynitrurée.

Cette fine couche de blocage oxydée et/ou nitrurée peut être aisément fabriquée sans altérer la couche fonctionnelle. Elle est, de préférence, déposée à partir d'une cible céramique, dans une atmosphère non oxydante constituée de préférence de gaz noble (He, Ne, Xe, Ar, Kr).

La fine couche de blocage peut être préférentiellement en nitrure et/ou oxyde sous-stoechiométrique pour encore davantage de reproductibilité des propriétés électriques et optiques de l'électrode.

La fine couche blocage choisie oxyde et/ou nitrure sous stoechiométrique peut être, de préférence à base d'un métal choisi parmi l'un au moins des métaux suivants : Ti, V, Mn, Fe, Co, Cu, Zn, Zr, Hf, Al, Nb, Ni, Cr, Mo, Ta, W, ou d'un oxyde d'un alliage sous stoechiométrique à base d'au moins un de ces matériaux.

On préfère en particulier une couche à base d'un oxyde ou d'oxynitrure d'un métal choisi parmi le niobium Nb, le tantale Ta, le titane Ti, le chrome Cr ou le nickel Ni ou d'un alliage à partir d'au moins deux de ces métaux, notamment d'un alliage de niobium et de tantale (Nb/Ta), de niobium et de chrome (Nb/Cr) ou de tantale et de chrome (Ta/Cr) ou de nickel et de chrome (Ni/Cr).

Comme nitrure métallique sous-stoechiométrique, on peut choisir aussi une couche en nitrure de silicium $SiN_x$ ou d'aluminium AlNx ou de chrome $Cr N_x$, ou de titane $TiN_x$ ou de nitrure de plusieurs métaux comme le $NiCrN_x$.

La fine couche de blocage peut présenter un gradient d'oxydation, par exemple $M(N)O_{xi}$ avec $x_i$ variable, la partie de la couche de blocage en contact avec la couche métallique est moins oxydée que la partie de cette couche la plus éloignée de la couche métallique en utilisant une atmosphère de dépôt particulière.

Le revêtement de blocage peut aussi être multicouche et notamment comprendre :

- d'une part une couche « d'interface » immédiatement en contact avec ladite couche fonctionnelle, cette couche d'interface étant en un matériau à base d'oxyde, de nitrure ou d'oxynitrure métallique non stoechiométrique, tels que ceux précités,

- d'autre part, d'au moins une couche en un matériau métallique, tels que ceux précités, couche immédiatement en contact avec ladite couche « d'interface ».

La couche d'interface peut être un oxyde, un nitrure ou un oxynitrure d'un métal ou de métaux qui est ou sont présent(s) dans la couche métallique adjacente éventuelle.

Naturellement, par souci de simplification, les première et deuxième couches de surblocage peuvent être en le même matériau et/ou les première et deuxième couches de sousblocage peuvent être en le même matériau.

Le substrat comporte par ailleurs, de préférence, une structure de bus-électrode inférieure au-dessus du revêtement électrode inférieur, ladite structure de bus-électrode étant en contact électrique avec ledit revêtement électrode.

La structure de bus-électrode inférieure se présente sous forme de couche pour l'amenée de courant avant la gravure ; elle est de préférence d'épaisseur comprise entre 0,5 à 10 μm et de préférence sous forme d'une monocouche en l'un des métaux suivants : Mo, Al, Cr, Nd ou en alliage tel que MoCr, AlNd ou sous forme d'une multicouche telle que MoCr/Al/MoCr.

Toutes les couches de l'électrode sont de préférence déposées par une technique de dépôt sous vide, mais il n'est toutefois pas exclu que la première ou les premières couches de l'empilement puisse(nt) être déposée(s) par une autre technique, par exemple par une technique de décomposition thermique de type pyrolyse.

L'ensemble des couches d'électrode, peut être, de préférence, gravé suivant un même motif de gravure et de préférence par une seule gravure, sauf la couche de fond qui, elle, n'est pas gravée. La couche d'arrêt de gravure, si elle est présente, est de préférence également intacte, mais peut se trouvée légèrement gravée, par exemple sur un dixième de son épaisseur initiale. Il en est de même pour la couche de fond si la couche d'arrêt de gravure n'est pas présente.

Le substrat peut être plan ou courbe, et en outre rigide, flexible ou semi-flexible.

Ses faces principales peuvent être rectangulaires, carrées ou même de toute autre forme (ronde, ovale, polygonale...). Ce substrat peut être de grande taille par exemple de surface supérieure à 0,02 m$^2$ voire même 0,5 m$^2$ ou 1 m$^2$ et avec une électrode inférieure (divisée éventuellement en plusieurs zones dites surfaces d'électrodes) occupant sensiblement la surface (aux zones de structuration près et/ou aux zones de bords près)

Le substrat est sensiblement transparent. Il peut présenter une transmission lumineuse $T_L$ supérieure ou égale à 70%, de préférence supérieure ou égale à 80% voire à 90%.

Le substrat peut être minéral ou en matière plastique comme du polycarbonate PC ou du polymétacrylate de méthyle PMMA ou encore un polyéthylène naphtalate PEN, un polyester, un polyimide, un poyestersulfone PES, un PET, un polytétrafluoréthylène PTFE, une feuille de matière thermoplastique par exemple du polyvinyle butyral PVB, polyuréthane PU, en éthylène vinylacétate EVA, ou en résine pluri ou mono-composants, réticulable thermiquement (époxy, PU) ou aux ultraviolets (époxy, résine acrylique) etc...

Le substrat peut être de préférence verrier, en verre minéral, en verre silicate, notamment en verre sodocalcique ou silicosodocalcique, un verre clair, extraclair, un verre float. Il peut s'agir d'un verre haut indice (notamment d'indice supérieur à 1,6)

Le substrat peut être avantageusement un verre présentant un coefficient d'absorption inférieur à 2,5 m$^{-1}$, de préférence inférieur à 0,7 m$^{-1}$ à la longueur d'onde des rayonnements OLEDs.

On choisit par exemple des verres silicosodocalciques avec moins de 0,05% de Fe III ou de $Fe_2O_3$, notamment le verre Diamant de Saint-Gobain Glass, le verre Optiwhite de Pilkington, le verre B270 de Schott. On peut choisir toutes les compositions de verre extraclair décrites dans le document WO04/025334.

Avec une émission du système OLED à travers l'épaisseur du substrat transparent, une partie du rayonnement émis est guidé dans le substrat. Aussi, dans une conception avantageuse de l'invention, l'épaisseur du substrat choisi verrier peut être d'au moins 1 mm, de préférence d'au moins 5 mm, par exemple. Cela permet de diminuer le nombre de réflexions internes et d'extraire ainsi plus de rayonnement guidé dans le verre, augmentant ainsi la luminance de la zone lumineuse.

Dans une configuration supplémentaire, le substrat selon l'invention comporte sur une deuxième face principale un revêtement fonctionnel choisi parmi : une multicouche antireflet, une couche antibuée ou antisalissures, un filtre ultraviolet, notamment une couche d'oxyde de titane, une couche luminophore, une couche miroir, une zone diffusante d'extraction de lumière.

En outre, il est en général préférable de munir le revêtement électrode de bus électrode avant le dépôt du système OLED. La couche qui va former les bus-électrodes est, de préférence, gravée en même temps que le revêtement électrode.

On peut utiliser le substrat tel que défini précédemment pour un dispositif OLED comportant au moins une zone d'électrode (pleine) de taille supérieure ou égale à 1x1 cm$^2$, voire 5x5 cm$^2$, même 10x10 cm$^2$ et au-delà.

On peut utiliser le substrat tel que défini précédemment pour un dispositif OLED formant un panneau d'éclairage, ou de rétroéclairage (sensiblement blanc et/ou uniforme) notamment de surface (pleine) d'électrode supérieure ou égale à 1x1 cm$^2$, voire jusqu'à 5x5 cm$^2$ même 10x10 cm$^2$ et au-delà.

Ainsi, l'OLED peut être conçue pour former un seul pavé éclairant (avec une seule surface d'électrode) en lumière polychromatique (sensiblement blanche) ou une multitude de pavés éclairants (avec plusieurs surfaces d'électrode) en lumière polychromatique (sensiblement blanche), chaque pavé éclairant doté d'une surface

(pleine) d'électrode supérieure ou égale à 1x1 cm$^2$, voire 5x5 cm$^2$, 10x10 cm$^2$ et au-delà.

Ainsi dans un dispositif OLED selon l'invention, notamment pour l'éclairage, on peut choisir une électrode non pixellisée. Elle se distingue d'une électrode pour écran (« LCD »...) formée de 3 pixels juxtaposés, généralement de très faibles dimensions, et émettant chacun un rayonnement donné quasi monochromatique (typiquement rouge , vert ou bleu).

Pour la réalisation d'un dispositif OLED, le substrat selon l'invention comportant en outre un système OLED, au-dessus de l'électrode inférieure telle que définie précédemment, prévu pour émettre un rayonnement polychromatique défini à 0° par des coordonnées (x1, y1) dans le diagramme colorimétrique CIE XYZ 1931, coordonnées données donc pour un rayonnement à la normale.

Le dispositif OLED peut être à émission par le bas et éventuellement aussi par le haut suivant que l'électrode supérieure est réfléchissante ou semi réfléchissante, ou même transparente (notamment de TL comparable à l'anode typiquement à partir de 60% et de préférence supérieure ou égale à 80%).

Le dispositif OLED peut comporter en outre :

- une électrode supérieure au-dessus dudit système OLED ;
- et de préférence une structure de bus-électrode supérieure au-dessus du revêtement électrode supérieur, ladite structure de bus-électrode étant en contact électrique avec ledit revêtement électrode supérieur.

Plus préférentiellement, on réalise un dispositif OLED émettant en sortie un spectre défini à 0° par ses coordonnées colorimétriques (x2, y2) dans le diagramme colorimétrique CIE XYZ 1931, telles que

$\sqrt{((x1-x2)^2+(y1-y2)^2)}$ est inférieure à 0,1 encore plus préférentiellement inférieure ou égale 0,08, voire inférieure ou égale à 0,03.

Le système OLED peut être adapté pour émettre une lumière (sensiblement) blanche, le plus proche possible des cordonnées (0,33 ; 0,33) ou des coordonnées (0,45 ; 0,41), notamment à 0°.

Pour produire de la lumière sensiblement blanche plusieurs méthodes sont possibles : mélange de composés (émission rouge vert, bleu) dans une seule couche, empilement sur la face des électrodes de trois structures organiques (émission rouge vert, bleu) ou de deux structures organiques (jaune et bleu).

Le dispositif OLED peut être adapté pour produire en sortie une lumière (sensiblement) blanche, le plus proche possible de cordonnées (0,33 ; 0,33), ou des coordonnées (0,45 ; 0,41), notamment à 0°.

Aussi, pour évaluer l'écart colorimétrique à 0°, on peut par exemple prendre pour (x1 ; y1) les coordonnées (0,33 ; 0,33), ou les coordonnées (0,45 ; 0,41).

En outre, pour apprécier la dépendance angulaire de la couleur une fois le dispositif OLED réalisé, on évalue la variation colorimétrique en fonction de l'angle $V_{color}$ c'est-à-dire la longueur du chemin, dans le diagramme colorimétrique CIE XYZ 1931, entre le spectre émis à 0° et le spectre émis à 60°, ceci en passant par au moins un angle intermédiaire comme par exemple 30°.

Ce chemin peut avoir des formes diverses comme une droite ou un arc de cercle par exemple. La mesure de la variation colorimétrique s'effectue en mesurant le spectre du dispositif électroluminescent à des angles différents (par exemple entre 0° et un angle limite donné $\theta_c$ égal à 60°, ceci tous les 5°) avec un spectrophotomètre. Ensuite, les coordonnées colorimétriques pour chaque spectre d'angle $\theta_t$ sont exprimées par le couple $(x(\theta_t);y(\theta_t))$ dans le diagramme colorimétrique CIE XYZ 1931.

La longueur du chemin $V_{color}$ peut être calculée en utilisant la formule suivante:

$$V_{color} = \sum_{\theta_i=0}^{\theta_i=\theta_c} \sqrt{\left(x(\theta_i)-x(\theta_{i+1})\right)^2 + \left(y(\theta_i)-y(\theta_{i+1})\right)^2}$$

La longueur du chemin $V_{color}$ est minimisée, et peut être ainsi inférieure ou égale à 0,1, encore plus préférentiellement inférieure ou égale à 0,08 voire à inférieure ou égale 0,05 voire 0,03. On peut encore optimiser davantage en minimisant la longueur du chemin entre 0° et 85°.

Le dispositif peut faire partie d'un vitrage multiple, notamment un vitrage sous vide ou avec lame d'air ou autre gaz. Le dispositif peut aussi être monolithique, comprendre un vitrage monolithique pour gagner en compacité et/ou en légèreté.

Le système OLED peut être collé ou de préférence feuilleté avec un autre substrat plan dit capot, de préférence transparent tel qu'un verre, à l'aide d'un intercalaire de feuilletage, notamment extraclair.

Les vitrages feuilletés sont usuellement constitués de deux substrats rigides entre lesquels est disposée une feuille ou une superposition de feuilles de polymère du type thermoplastique. L'invention inclut aussi les vitrages feuilletés dits « asymétriques » utilisant un substrat notamment porteur rigide du type verre et comme substrat couvrant une ou des feuilles protectrices de polymère.

L'invention inclut aussi les vitrages feuilletés ayant au moins une feuille intercalaire à base d'un polymère adhésif simple ou double face du type élastomère (c'est-à-dire ne nécessitant pas une opération de feuilletage au sens classique du terme, feuilletage imposant un chauffage généralement sous pression pour ramollir et rendre adhérente la feuille intercalaire thermoplastique).

Dans cette configuration, le moyen pour solidariser capot et substrat porteur peut être alors un intercalaire de feuilletage notamment une feuille de matière thermoplastique par exemple en polyuréthane (PU), en polyvinylbutyral (PVB), en éthylène vinylacétate (EVA), ou être en résine pluri ou mono-composants réticulables thermiquement (époxy, PU) ou aux ultraviolets (époxy, résine acrylique). Elle est de préférence (sensiblement) de même dimension que le capot et le substrat.

L'intercalaire de feuilletage peut permettre d'éviter un fléchissement du capot notamment pour des dispositifs de grande dimension par exemple de surface supérieure à 0,5m$^2$.

L'EVA offre en particulier de multiples avantages :

- il n'est pas ou peu chargé en eau en volume,
- il ne nécessite pas nécessairement une mise sous pression élevée pour sa mise en oeuvre.

Un intercalaire de feuilletage thermoplastique peut être préféré à une couverture en résine coulée car elle est à la fois plus facile à mettre en oeuvre, plus économique et est éventuellement plus étanche.

L'intercalaire comporte éventuellement un réseau de fils électroconducteurs incrustés sur sa surface, dite interne, en regard de l'électrode supérieure, et/ou une couche électroconductrice ou des bandes électroconductrices sur la surface interne du capot.

Le système OLED peut être disposé de préférence à l'intérieur du double vitrage, avec une lame de gaz notamment inerte (argon par exemple).

L'électrode supérieure peut être une couche électroconductrice avantageusement choisie parmi les oxydes métalliques notamment les matériaux suivants :

- l'oxyde de zinc dopé, notamment à l'aluminium ZnO:Al ou au gallium ZnO:Ga,
- ou encore l'oxyde d'indium dopé, notamment à l'étain (ITO) ou l'oxyde d'indium dopé au zinc (IZO).

On peut utiliser plus généralement tout type de couche électroconductrice transparente, par exemple une couche dite « TCO » (pour « Transparent Conductive Oxyde » en anglais), par exemple d'épaisseur entre 20 et 1000 nm, typiquement 120 nm pour l'ITO

On peut aussi utiliser une couche mince métallique dite « TCC » (pour « Transparent conductive coating » en anglais) par exemple en Ag, Al, Pd, Cu, Pd, Pt In, Mo, Au et typiquement d'épaisseur entre 5 et 150 nm en fonction de la transmission/réflexion lumineuse souhaitée. Par exemple une couche d'argent est transparente en dessous de 15 nm, opaque à partir de 40 nm.

L'électrode n'est pas forcément continue. L'électrode supérieure peut comprendre une pluralité de bandes conductrices ou de fils conducteurs (grille).

En outre, il peut être avantageux d'ajouter un revêtement ayant une fonctionnalité donnée sur la face opposée du substrat porteur de l'électrode selon l'invention ou sur un substrat additionnel. Il peut s'agir d'une couche anti-buée (à l'aide d'une couche hydrophile), anti-salissures (revêtement photocatalytique comprenant du TiO$_2$ au moins partiellement cristallisé sous forme anatase), ou encore un empilement anti-reflet du type par exemple Si$_3$N$_4$/SiO$_2$/Si$_3$N$_4$/SiO$_2$ ou encore un filtre aux UV comme par exemple une couche d'oxyde de titane (TiO$_2$). Il peut en outre s'agir d'une ou plusieurs couches luminophores, d'une couche miroir, d'au moins une zone diffusante d'extraction de lumière.

L'invention concerne également les diverses applications que l'on peut trouver à ces dispositifs OLEDS, formant une ou des surfaces lumineuses transparentes et/ou réfléchissantes (fonction miroir) disposés aussi bien en extérieur qu'en intérieur.

Le dispositif peut former (choix alternatif ou cumulatif) un système éclairant, décoratif, architectural, etc.), un panneau d'affichage de signalisation - par exemple du type dessin, logo, signalisation alphanumérique, notamment un panneau d'issue de secours.

Le dispositif OLED peut être arrangé pour produire une lumière polychromatique uniforme, notamment pour un éclairage homogène, ou pour produire différentes zones lumineuses, de même intensité ou d'intensité distincte.

Inversement, on peut rechercher un éclairage polychromatique différencié. Le système électroluminescent organique (OLED) produit une zone de lumière directe, et une autre zone lumineuse est obtenue par extraction du rayonnement OLED qui est guidé par réflexion totale dans l'épaisseur du substrat choisi verrier.

Pour former cette autre zone lumineuse, la zone d'extraction peut être adjacente au système OLED ou de l'autre côté du substrat. La ou les zones d'extraction peuvent servir par exemple pour renforcer l'éclairage fourni par la zone de lumière directe, notamment pour un éclairage de type architectural, ou encore pour signaler le panneau lumineux. La ou les zones d'extraction sont de préférence sous forme de bande(s) de lumière, notamment uniforme(s), et préférentiellement disposée(s) en périphérie d'une des faces. Ces bandes peuvent par exemple former un cadre très lumineux.

L'extraction est obtenue par l'un au moins des moyens suivants disposés dans la zone extraction : une couche diffusante, le substrat rendu diffusant, notamment texturé ou rugueux.

Lorsque les électrodes et la structure organique du système OLED sont choisies transparentes, on peut réaliser notamment une fenêtre éclairante. L'amélioration de l'éclairage de la pièce n'est alors pas réalisée au détriment de la transmission lumineuse. En limitant en outre la réflexion lumineuse notamment du côté extérieur de la fenêtre éclairante, cela permet aussi de contrôler le niveau de réflexion par exemple pour respecter les normes anti-éblouissement en vigueur pour les façades de bâtiments.

Plus largement, le dispositif, notamment transparent par partie(s) ou entièrement, peut être :

- destiné au bâtiment, tel qu'un vitrage lumineux extérieur, une cloison lumineuse interne ou une (partie de) porte vitrée lumineuse notamment coulissante,
- destiné à un véhicule de transport, tel qu'un toit lumineux, une (partie de) vitre latérale lumineuse, une cloison lumineuse interne d'un véhicule terrestre, aquatique ou aérien (voiture, camion train, avion, bateau, etc.),
- destiné au mobilier urbain ou professionnel tel qu'un panneau d'abribus, une paroi d'un présentoir, d'un étalage de bijouterie ou d'une vitrine, une paroi d'une serre, une dalle éclairante,
- destiné à l'ameublement intérieur, un élément d'étagère ou de meuble, une façade d'un meuble, une dalle éclairante, un plafonnier, une tablette éclairante de réfrigérateur, une paroi d'aquarium,
- destiné au rétro-éclairage d'un équipement électronique, notamment d'écran de visualisation ou d'affichage, éventuellement double écran, comme un écran de télévision ou d'ordinateur, un écran tactile.

Pour former un miroir éclairant, l'électrode supérieure peut être réfléchissante

Il peut être aussi un miroir. Le panneau lumineux peut servir à l'éclairage d'une paroi de salle de bains ou d'un plan de travail de cuisine, être un plafonnier.

Les OLED sont généralement dissociés en deux grandes familles suivant le matériau organique utilisé.

Si les couches électroluminescentes sont des petites molécules, on parle de SM-OLED (« Small Molecule Organic Light Emitting Diodes » en anglais).

D'une manière générale la structure d'une SM-OLED consiste en un empilement de couches d'injection de trous ou « HIL » pour « Hole Injection Layer » en anglais, couche de transport de trous ou « HTL » pour « Hole Transporting Layer » en anglais, couche émissive, couche de transport d'électron ou « ETL » pour « Electron Transporting Layer » en anglais.

Des exemples d'empilements électroluminescents organiques sont par exemple décrits dans le document intitulé « four wavelength white organic light emitting diodes using 4, 4'- bis- [carbazoyl-(9)]- stilbene as a deep blue emissive layer » de C.H. Jeong et autres, publié dans Organics Electronics 8 (2007) pages 683-689.

Si les couches électroluminescentes organiques sont des polymères, on parle de PLED (« Polymer Light Emitting Diodes » en anglais).

La ou les couches organiques d'OLED sont généralement d'indice à partir de 1,8 voire au delà (1,9 même plus).

De préférence, le dispositif OLED peut comporter un système OLED plus ou moins épais par exemple compris entre 50 et 350 nm ou 300 nm, notamment entre 90 et 130 nm, voire entre 100 et 120 nm.

La position des émetteurs de chaque famille dans les cavités peut influer sur l'ajustement fin de L2 et/ou de L1.

L'invention sera maintenant décrite plus en détails à l'aide d'exemples non limitatifs et de figures :

- La figure 1 est une vue schématique en coupe d'un dispositif électroluminescent organique, pour un éclairage uniforme, lequel comprend une électrode inférieure conforme à l'invention dans un premier mode de réalisation,
- la figure 2 est une vue partielle montrant cette électrode inférieure plus en détail,
- la figure 3 est une vue montrant dans le diagramme colorimétrique différentes longueurs de chemins,
- la figure 4 montre des spectres de dispositifs OLEDs.

On précise que par un souci de clarté les différents éléments des objets (y compris les angles) représentés ne sont pas nécessairement reproduits à l'échelle.

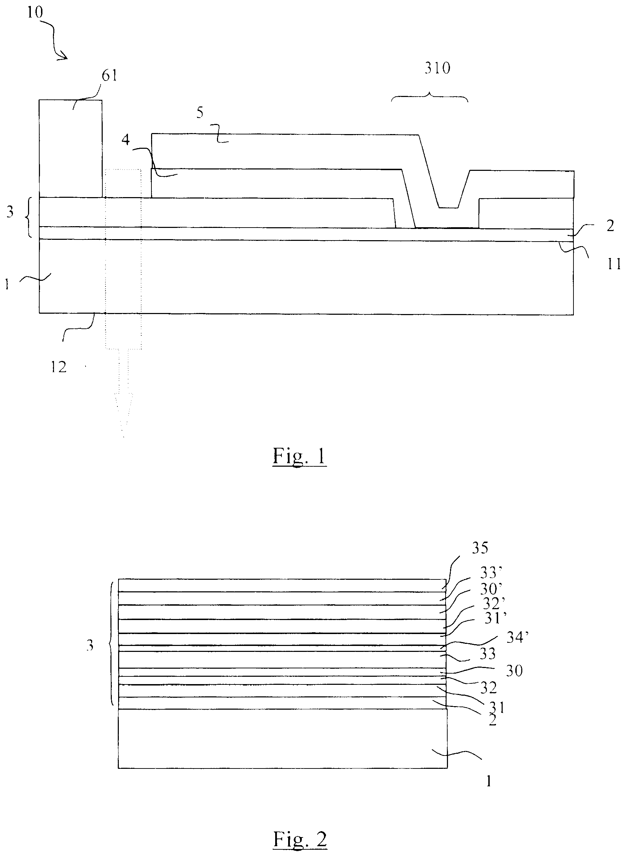

La figure 1 est volontairement très schématique. Elle représente en coupe un dispositif électroluminescent organique 10 (à émission à travers le substrat ou « bottom emission » en anglais) comprenant successivement :

- un substrat plan 1 de verre silico-sodo-calcique éventuellement clair ou extraclair par exemple à partir de 0,7 mm d'épaisseur, avec des première et deuxième faces principales 11, 12, la première face principale 11 comportant d'abord une électrode inférieure (semi) transparente 3, comportant l'empilement de couches (voir figure 2) suivant :
- une sous couche antireflet comportant :

    - une couche de fond 2, déposée directement sur la première face principale 11, en nitrure de silicium et couvrant sensiblement la totalité de la première face principale 11,
    - une première couche de lissage 31 en $Sn_yZn_zO_x$ dopée à l'antimoine Sb, qui en variante est déposée directement sur la face 11,
    - une première couche de contact 32 en $ZnO_x$ dopée à l'aluminium,

- une première couche métallique 30, de préférence en argent par exemple pur,
- une première couche séparatrice comportant :

    - éventuellement un revêtement de surblocage 33 sus-jacent, directement sur la couche métallique 32,
    - éventuellement une couche additionnelle 34 en $ZnO_x$ dopée à l'aluminium,
    - une deuxième couche de lissage 31' en $Sn_yZn_zO_x$ dopée à l'antimoine Sb,
    - une deuxième couche de contact 32' en $ZnO_x$ dopée à l'aluminium,

- une deuxième couche métallique 30', de préférence en argent par exemple pur,
- éventuellement un revêtement de surblocage 33',
- une surcouche 35 d'adaptation du travail de sortie, en ITO.

Le dispositif 10 comporte en outre sur l'électrode 3 :

- un système électroluminescent organique 4, par exemple un SM-OLED émettant une lumière blanche formée de :

    - 45 nm de 2-TNATA,
    - 15 nm de NPB (10 nm),
    - 5 nm de NPB : DCJTB (0,2% en poids),
    - 6 nm de BCS : perylene (0,5% en poids),
    - 1 nm de $Alq_3$ :C545T (0,2% en poids),
    - 50 nm de $Alq_3$,
    - 1 nm de Li.

Ces couches sont décrites dans le document intitulé « four wavelength white organic light emitting diodes using 4, 4'- bis- [carbazoyl-(9)]- stilbene as a deep blue emissive layer » de C.H. Jeong et autres, publié dans Organics Electronics 8 (2007) pages 683-689.

Le dispositif 10 comporte en outre sur le système OLED 4:

- une électrode supérieure métallique 5, (semi) réfléchissante, notamment à base d'argent ou d'aluminium.

Une série d'exemples 1 à 5 de dépôt d'empilements pour réaliser l'électrode inférieure selon l'invention a été réalisée par pulvérisation cathodique assistée par champ magnétique, à température ambiante, en général le substrat 1.

A titre comparatif, on présente aussi :

- un exemple construit n°6 d'électrode à base d'une seule couche d'argent entre une sous couche antireflet et une surcouche,
- un exemple classique n°7 d'électrode à base d'ITO.

Le tableau 1 ci-après résume la nature et l'épaisseur géométrique en nanomètres des différentes couches de ces exemples, ainsi que leurs principales caractéristiques optiques et électriques.

Tableau 1

| Exemples | n°1 | N°2 | n°3 | n°4 | n°5 | n°6 comparatif | n°7 comparatif |
|---|---|---|---|---|---|---|---|
| Couches/ e(nm) | | | | | | | |
| ITO | | | | | | | 120 |
| $Si_3N_4$ | 30 | 23 | 26 | 15 | | 21 | |
| SnZnO | 5 | 7 | 4 | 6 | 45 | 5 | |
| ZnO | 5 | 3 | 6 | 4 | 5 | 5 | |
| Ag | 8 | 9 | 11 | 9 | 8 | 12 | |
| Ti | 0,5 | < 1 | < 1 | < 1 | < 1 | 0,5 | |
| ZnO | 5 | 5 | 5 | 5 | 5 | | |
| SnZnO | 60 | 46 | 49 | 39 | 75 | | |
| ZnO | 5 | 5 | 5 | 5 | 5 | | |
| Ag | 8 | 8 | 8 | 8 | 8 | | |
| Ti | 0,5 | < 1 | < 1 | < 1 | < 1 | | |
| ITO | 20 | 22 | 18 | 32 | 50 | 10 | |
| Propriétés de l'empilement | | | | | | | |
| L1 (nm) | 80 | 65 | 70 | 50 | 100 | | |
| L2 (nm) | 140 | 110 | 115 | 100 | 170 | | |
| $T_L$ (%) | 80 | 80 | 77 | 75 | | 65 | 85 |
| R par carré ($\Omega$/carré) | 2,7 | 2,6 | 2,4 | 2,6 | | 3,5 | 15 |

Les conditions de dépôt pour chacune des couches sont les suivantes :

- les couches à base de $Si_3N_4$:Al sont déposées par pulvérisation réactive à l'aide d'une cible en silicium dopée à l'aluminium, sous une pression de 0,25 Pa dans une atmosphère argon/azote,
- les couches à base de $SnZn$:$SbO_x$ sont déposées par pulvérisation réactive à l'aide d'une cible de zinc et d'étain dopée à l'antimoine comportant en masse 65 % de Sn, 34 % de Zn et 1 % de Sb, sous une pression de 0,2 Pa et dans une atmosphère argon/oxygène,
- les couches à base d'argent sont déposées à l'aide d'une cible en argent, sous une pression de 0,8 Pa dans une atmosphère d'argon pur,
- les couches de Ti sont déposées à l'aide d'une cible titane, sous une pression de 0,8 Pa dans une atmosphère d'argon pur,
- les couches à base de ZnO:Al sont déposées par pulvérisation réactive à l'aide d'une cible de zinc dopé aluminium, sous une pression de 0,2 Pa et dans une atmosphère argon/oxygène,
- les surcouches à base d'ITO sont déposées à l'aide d'une cible céramique dans une atmosphère argon/oxygène, sous une pression de 0,2 Pa et dans une atmosphère argon/oxygène.

L'électrode inférieure peut en variante comprendre un revêtement de blocage sous-jacent, comportant notamment, comme le revêtement de blocage sus-jacent, une couche métallique obtenue de préférence par une cible métallique avec un plasma neutre ou en nitrure et/ou oxyde d'un ou plusieurs métaux tels que Ti, Ni, Cr, obtenue de préférence par une cible céramique avec un plasma neutre.

L'électrode inférieure 3 déborde sur un côté du substrat 1. La bordure de la surcouche 35 est ainsi surmontée d'une première bande métallique 61 d'amenée de courant, de préférence d'épaisseur comprise entre 0,5 à 10 $\mu$m, par exemple 5 $\mu$m, et sous forme d'une couche en l'un des métaux suivants : Mo, Al, Cr, Nd ou en alliage tel que MoCr, AlNd ou en multicouche tel que MoCr/Al/MoCr.

L'électrode supérieure déborde sur le côté opposé du substrat 1. Cette bordure de l'électrode supérieure 5 est éventuellement surmontée d'une deuxième bande métallique d'amenée de courant, de préférence similaire à la première bande métallique. Cette deuxième bande est préférable dans le cas où l'électrode supérieure est d'épaisseur inférieure ou égale à 50 nm.

L'électrode supérieure peut en effet aussi être, en variante, une électrode transparente ou semi transparente, par exemple une couche d'aluminium. Elle peut aussi par exemple être identique ou similaire à l'électrode inférieure. On rapporte éventuellement dans ce cas un réflecteur sur la deuxième face 12 par exemple une couche métallique d'épaisseur 150 nm.

Une feuille type EVA peut permettre de feuilleter le substrat 1 à un autre verre de préférence de mêmes caractéristiques que le substrat 1. Optionnellement, la face 12 du verre 1 tournée vers la feuille d'EVA est munie d'un empilement de fonctionnalité donnée décrite plus tard.

L'électrode inférieure 3 est en deux parties espacées par la zone de gravure 310.

La gravure humide est utilisée pour séparer électriquement l'électrode inférieure 3 de l'électrode supérieure 5 du dispositif 10.

Le tableau 2 ci-après résume les propriétés optiques du dispositif OLED des exemples précités 1 à 5 et des comparatifs 6 et 7, notamment en prenant comme référence l'illuminant E.

Tableau 2

| Exemples | n°1 | n°2 | n°3 | n°4 | n°6 comparatif | n°7 comparatif |
|---|---|---|---|---|---|---|
| Coordonnées colorimétriques à 0° (x2 ; y2) | (0,38; 0,4) | (0,36; 0,35) | (0,34; 0,35) | (0,33; 0,33) | (0,40; 0,42) | (0,36; 0,35) |
| Ecart colorimétrique à 0°par rapport à l'émetteur blanc (0,33 ; 0,33) | 0,081 | 0,031 | 0,018 | 0,005 | 0,109 | 0,031 |
| Dépendance angulaire $V_{color}$ | 0,08 | 0,03 | 0,030 | 0,02 | 0,13 | 0,07 |
| Efficacité d'extraction* | 24% | 23% | 24% | 21% | 26% | 21% |

Pour calculer l'efficacité d'extraction, on calcule d'abord le rendement quantique externe Pout/Pin c'est-à-dire le rapport entre la puissance électrique Pout injectée dans le dispositif OLED et la puissance lumineuse Pin intégrée entre 0 et 85°. Ensuite, en considérant un rendement quantique interne de 25%, on divise le rendement quantique externe par 0,25 pour obtenir l'efficacité d'extraction.

Le tableau 3 ci-après résume les propriétés optiques du dispositif OLED de l'exemple précité 6 notamment en prenant comme référence l'illuminant A.

Tableau 3

| Exemple | n°5 |
|---|---|
| Coordonnées colorimétriques à 0° (x2 ; y2) | (0,43 ; 0,48) |
| Ecart colorimétrique à 0°par rapport à l'émetteur « jaune » (0,45 ; 0,41) | 0,07 |
| Dépendance angulaire $V_{color}$ | 0,04 |

Les valeurs des tableaux 2 et 3 montrent que l'électrode bicouche argent (exemples 1 à 5) permet d'obtenir une très faible dépendance colorimétrique angulaire et ne pénalise pas l'efficacité d'extraction.

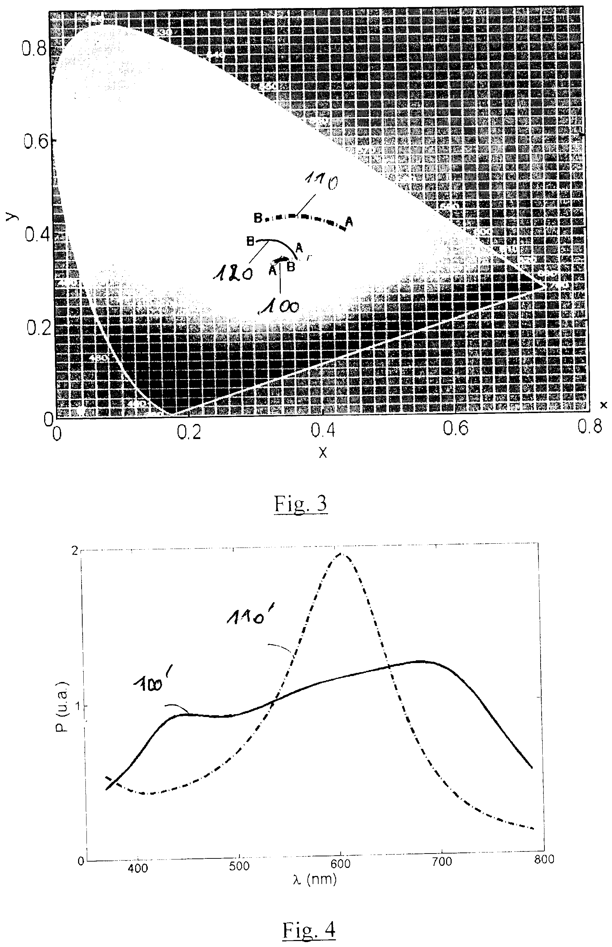

La figure 3 montre l'évolution des coordonnées colorimétriques dans le diagramme colorimétrique CIE XYZ 1931 en fonction de l'angle d'observation dans l'air pour les exemples 2 (courbe 100) 6 (courbe 110), 7 (courbe 120).

On voit ainsi que le chemin le plus court et proche du blanc émetteur (0,33 ; 0,33) correspond à l'électrode bicouche argent.

La figure 4 montre les spectres des dispositifs OLED pour les exemples 2 (courbe 100') 6 (courbe 110') à 0°.

On voit ainsi que le spectre 100' obtenu grâce à l'électrode bicouche est relativement plat sur une large partie du spectre visible contrairement au spectre 110'.

Il va de soi que l'invention s'applique de la même manière aux systèmes utilisant d'autres systèmes électroluminescents que ceux décrits dans les exemples.

La présente invention est décrite dans ce qui précède à titre d'exemple. Il est entendu que l'homme du métier est à même de réaliser différentes variantes de l'invention sans pour autant sortir du cadre du brevet tel que défini par les revendications.

**Revendications**

1. Dispositif électroluminescent organique (10) incorporant un substrat (1), d'indice optique n0, porteur d'une électrode inférieure, d'un système organique électroluminescent au-dessus de l'électrode inférieure et émettant un rayonnement polychromatique défini à 0° par des coordonnées (x1, y1) dans le diagramme colorimétrique CIE XYZ 1931 et d'une électrode supérieure au-dessus du système organique électroluminescent, l'électrode inférieure comportant un empilement comportant successivement :

   - une sous couche antireflet d'épaisseur optique L1 donnée et d'indice optique n1 tel que le rapport n1 sur n0 est supérieur ou égal à 6/5, la sous couche antireflet comportant une couche, dite première couche de contact (32), à base d'oxyde métallique, sous jacente à la première couche métallique, la première couche de contact (32) étant à base d'oxyde de zinc éventuellement sous stoechiométrique et/ou éventuellement dopé,
   - une première couche métallique (30) d'épaisseur e1 donnée, disposée sur la sous couche antireflet,
   - une première couche séparatrice, d'épaisseur optique L2 donnée, disposée sur la première couche métallique, la première couche séparatrice comporte une couche, dite deuxième couche de contact (32'), à base d'oxyde métallique sous jacente à la deuxième couche métallique, la deuxième couche de contact (32') étant à base d'oxyde de zinc éventuellement sous stoechiométrique et/ou éventuellement dopé,
   - une deuxième couche métallique (30'), à propriété intrinsèque de conductivité électrique, d'épaisseur e2 donnée, cette deuxième couche étant disposée entre la première couche séparatrice et la surcouche,
   - une surcouche d'adaptation du travail de sortie (35), d'épaisseur e3 donnée, disposée sur la deuxième couche métallique, la surcouche ayant un travail de sortie supérieur à 4,5 eV, la surcouche étant la couche supérieure de l'empilement

   la somme des épaisseurs e1+e2 des première et deuxième couches métalliques étant inférieure ou égale à 40 nm, L1 étant comprise entre 20 nm et 120 nm, L2 étant comprise entre 75 nm et 200 nm, des microcavités résonantes sont formées respectivement entre la première couche mince métallique et l'électrode supérieure, entre la deuxième couche mince métallique et l'électrode supérieure, à deux longueurs d'onde distinctes dans le visible et suffisamment espacées, notamment d'au moins 100 nm, et les valeurs de L1 et L2 sont ajustées afin d'élargir les deux pics de résonances et former un unique spectre large bande dans le visible.

2. Dispositif électroluminescent organique (10) selon la revendication 1 *caractérisé en ce qu*'il émet en sortie un spectre défini à 0° par ses coordonnées colorimétriques (x2, y2) dans le diagramme colorimétrique CIE XYZ 1931, telles que $\sqrt{((x1-x2)^2 + (y1-y2)^2)}$ est inférieure à 0,1

3. Dispositif électroluminescent organique (10) selon l'une des revendications 1 à 2 *caractérisé en ce qu*'il émet en sortie un spectre défini à 0° par ses coordonnées colorimétriques (x2, y2) dans le diagramme colorimétrique CIE XYZ 1931 et en ce que la longueur du chemin, dans le diagramme colorimétrique CIE XYZ 1931, entre le spectre émis à 0° et le spectre émis à 60° est inférieure ou égale à 0,1.

4. Dispositif électroluminescent organique (10) selon l'une des revendications 1 à 3 **caractérisé en ce que** la longueur du chemin, dans le diagramme colorimétrique CIE XYZ 1931, entre le spectre émis à 0° et le spectre émis à 60° est inférieure ou égale à 0,05.

5. Dispositif électroluminescent organique (10) selon l'une des revendications 1 à 4 **caractérisé en ce qu'**il forme une ou des surfaces lumineuses transparentes et/ou réfléchissantes, notamment un système éclairant, décoratif, architectural, un panneau d'affichage de signalisation par exemple du type dessin, logo, signalisation alphanumérique, le système produisant une lumière uniforme ou des zones lumineuses différenciées notamment par extraction de lumière guidée dans le substrat verrier.

6. Dispositif électroluminescent organique (10) selon la revendication 1 **caractérisé en ce que** L1 est inférieure ou égale à 100 nm et/ou L2 est inférieure ou égale à 160 nm.

7. Dispositif électroluminescent organique (10) selon la revendication 1 **caractérisé en ce que** L1 est inférieure ou égale à 80 nm et/ou L2 est inférieure ou égale à 130 nm.

8. Dispositif électroluminescent organique (10) selon la revendication 1 **caractérisé en ce que** L1 est inférieure à L2.

**9.** Application du dispositif électroluminescent organique (10) selon l'une des revendications 1 à 5:

- au bâtiment, tel qu'un vitrage lumineux extérieur, une cloison lumineuse interne ou une (partie de) porte vitrée lumineuse notamment coulissante,
- à un véhicule de transport, tel qu'un toit lumineux, une (partie de) vitre latérale lumineuse, une cloison lumineuse interne d'un véhicule terrestre, aquatique ou aérien.
- au mobilier urbain ou professionnel tel qu'un panneau d'abribus, une paroi d'un présentoir ou d'une vitrine, une paroi d'une serre, une dalle éclairante,
- à l'ameublement intérieur, tel qu'un élément d'étagère ou de meuble, une façade d'un meuble, une dalle éclairante, un plafonnier, une tablette éclairante de réfrigérateur, une paroi d'aquarium,
- au rétro-éclairage d'un équipement électronique, notamment d'un écran de visualisation ou d'affichage éventuellement double écran, comme un écran de télévision ou d'ordinateur, un écran tactile,
- à un miroir éclairant, notamment pour l'éclairage d'une paroi de salle de bains ou d'un plan de travail de cuisine, ou pour être un plafonnier.

**Patentansprüche**

**1.** Organisches lichtemittierendes Element (10), umfassend ein Substrat (1) mit dem optischen Index n0, Träger einer unteren Elektrode eines organischen lichtemittierenden Systems unter der unteren Elektrode und eine polychromatische Strahlung aussendend, die durch Koordinaten (x1, y1) im kolorimetrischen Diagramm CIE XYZ 1931 bei 0° liegend definiert ist, und einer oberen Elektrode über dem organischen lichtemittierenden System, wobei die untere Elektrode eine Schichtung umfasst, die sukzessiv Folgendes umfasst:

- eine Antireflex-Unterschicht mit der gegebenen optischen Dicke L1 und dem optischen Index n1, so dass das Verhältnis n1 zu n0 größer oder gleich 6/5 ist, wobei die Antireflex-Unterschicht eine als erste Kontaktschicht (32) bezeichnete Schicht auf der Basis eines Metalloxids unter der ersten Metallschicht umfasst, wobei die erste Kontaktschicht (32) auf der Basis von eventuell unterstöchiometrischem und/oder eventuell dotiertem Zinkoxid vorliegt,
- eine erste Metallschicht (30) der gegebenen Dicke e1, angeordnet auf der Antireflex-Unterschicht,
- eine erste Trennschicht mit der gegebenen optischen Dicke L2, angeordnet auf der ersten Metallschicht, wobei die erste Trennschicht eine als zweite Kontaktschicht (32') bezeichnete Schicht auf der Basis von Metalloxid unter der zweiten Metallschicht umfasst, wobei die zweite Kontaktschicht (32') auf der Basis von eventuell unterstöchiometrischem und/oder eventuell dotiertem Zinkoxid vorliegt,
- eine zweite Metallschicht (30') mit der immanenten Eigenschaft der elektrischen Leitfähigkeit mit der gegebenen Dicke e2, wobei diese zweite Schicht zwischen der ersten Trennschicht und der Oberschicht angeordnet ist,
- eine Ausgangsarbeitsanpassungsoberschicht (35) mit der gegebenen Dicke e3, angeordnet auf der zweiten Metallschicht, wobei die Oberschicht eine Ausgangsarbeit über 4,5 eV aufweist, wobei die Oberschicht die obere Schicht der Schichtung ist, wobei die Summe der Dicken e1+e2 der ersten und der zweiten Metallschicht kleiner oder gleich 40 nm ist, L1 zwischen 20 nm und 120 nm liegt, L2 zwischen 75 nm und 200 nm liegt, resonante Mikrokavitäten jeweils zwischen der ersten dünnen Metallschicht und der oberen Elektrode, zwischen der zweiten dünnen Metallschicht und der oberen Elektrode mit zwei unterschiedlichen Wellenlängen im sichtbaren Bereich und ausreichend beabstandet gebildet sind, insbesondere mit weniger als 100 nm, und die Werte von L1 und L2 angepasst sind, um die beiden Resonanzspitzen zu vergrößern und ein großes Band eines einzigen Spektrums im sichtbaren Bereich zu bilden.

**2.** Organisches lichtemittierendes Element (10) nach Anspruch 1, **dadurch gekennzeichnet, dass** es im Ausgang ein Spektrum emittiert, das durch seine Koordinaten (x2, y2) im kolorimetrischen Diagramm CIE XYZ 1931 bei 0° liegend definiert ist, so dass $\sqrt{((x1-x2)^2+(y1-y2)^2)}$ kleiner als 0,1 ist.

**3.** Organisches lichtemittierendes Element (10) nach einem der Ansprüche 1 bis 2, **dadurch gekennzeichnet, dass** es im Ausgang ein Spektrum emittiert, das durch seine Koordinaten (x2, y2) im kolorimetrischen Diagramm CIE XYZ 1931 bei 0° liegend definiert ist, und dadurch, dass die Länge des Weges im kolorimetrischen Diagramm CIE XYZ 1931 zwischen dem bei 0° emittierten Spektrum und dem bei 60° emittierten Spektrum kleiner oder gleich 0,1 ist.

**4.** Organisches lichtemittierendes Element (10) nach einem der Ansprüche 1 bis 3, **dadurch gekennzeichnet, dass** die Länge des Weges im kolorimetrischen Diagramm CIE XYZ 1931 zwischen dem bei 0° emittierten Spektrum und dem bei 60° emittierten Spektrum kleiner oder gleich 0,05 ist.

5. Organisches lichtemittierendes Element (10) nach einem der Ansprüche 1 bis 4, **dadurch gekennzeichnet, dass** es eine oder mehrere transparente und/oder reflektierende Leuchtoberflächen bildet, insbesondere ein leuchtendes, dekoratives, architektonisches System, eine Anzeigetafel zur Anzeige beispielsweise vom Typ Grafik, Logo, alphanumerische Anzeige, wobei das System ein gleichmäßiges Licht oder differenzierte Leuchtzonen erzeugt, insbesondere durch Extraktion von Licht, das im Glassubtrat geleitet wird.

6. Organisches lichtemittierendes Element (10) nach Anspruch 1, **dadurch gekennzeichnet, dass** L1 kleiner oder gleich 100 nm ist und/oder L2 kleiner oder gleich 160 nm ist.

7. Organisches lichtemittierendes Element (10) nach Anspruch 1, **dadurch gekennzeichnet, dass** L1 kleiner oder gleich 80 nm ist und/oder L2 kleiner oder gleich 130 nm ist.

8. Organisches lichtemittierendes Element (10) nach Anspruch 1, **dadurch gekennzeichnet, dass** L1 kleiner als L2 ist.

9. Anwendung des organischen lichtemittierenden Elements (10) nach einem der Ansprüche 1 bis 5:

   - am Gebäude wie etwa eine äußere Leuchtverglasung, eine innere Leuchttrennwand oder eine Leuchtglastür, insbesondere Schiebetür (oder ein Teil davon),
   - an einem Transportfahrzeug wie etwa ein Leuchtdach, eine seitliche Leuchtglasscheibe (oder ein Teil davon), eine innere Leuchttrennwand eines Land-, Wasser- oder Luftfahrzeugs,
   - am Stadt- oder Fachmobiliar wie etwa eine Tafel eines Wartehäuschens, eine Wand eines Ausstellungstandes oder Schaufensters, eine Wand eines Glashauses, eine Leuchtfliese,
   - an Innenraummobiliar wie etwa ein Regal- oder Möbelelement, eine Möbelfront, eine Leuchtfliese, eine Deckenleuchte, ein Leuchteinlegeboden im Kühlschrank, eine Aquariumswand,
   - bei der Hinterleuchtung eines elektronischen Gerätes, insbesondere eines Visualisierungsbildschirms oder einer Anzeige eventuell als Doppelbildschirm, wie ein Fernseh- oder Computerbildschirm, ein Tastbildschirm,
   - an einem Leuchtspiegel, insbesondere zur Beleuchtung einer Badezimmerwand oder einer Küchenarbeitsfläche oder als Deckenleuchte.

## Claims

1. Organic light-emitting device (10) incorporating a substrate (1) having an optical index n0, bearing a lower electrode, an organic light-emitting system on top of the lower electrode and that emits a polychromatic radiation defined at 0° by coordinates (x1, y1) in the CIE XYZ 1931 chromaticity diagram, and an upper electrode on top of the organic light-emitting system, the lower electrode comprising a stack successively composed of:

   - an anti-reflection sublayer having a given optical thickness L1 and having an optical index n1 such that the ratio of n1 to n0 is greater than or equal to 6/5, the anti-reflection sublayer comprising a layer, known as a first contact layer (32), based on a metal oxide, subjacent to the first metallic layer, the first contact layer (32) being based on optionally substoichiometric and/or optionally doped zinc oxide,
   - a first metallic layer (30) having a given thickness e1, positioned on the anti-reflection sublayer;
   - a first separating layer, having a given optical thickness L2, positioned on the first metallic layer, the first separating layer comprises a layer, known as a second contact layer (32'), based on a metal oxide, subjacent to the second metallic layer, the second contact layer (32') being based on optionally substoichiometric and/or optionally doped zinc oxide,
   - a second metallic layer (30'), having an intrinsic electrical conductivity property, and having a given thickness e2, this second layer being positioned between the first separating layer and the overlayer;
   - an overlayer (35) for adapting the work function, having a given thickness e3, positioned on the second metallic layer, the overlayer having a work function greater than 4.5 eV, the overlayer being the upper layer of the stack,

   the sum of the thicknesses e1+e2 of the first and second metallic layers being less than or equal to 40 nm; L1 being between 20 nm and 120 nm, L2 being between 75 nm and 200 nm, microcavities are formed that resonate, respectively between the first thin metallic layer and the upper electrode, and between the second thin metallic layer and the upper electrode, at two different wavelengths in the visible region that are sufficiently spaced apart, in particular by at least 100 nm, and the values of L1 and L2 are adjusted so as to broaden the two resonance peaks and form a single broadband spectrum in the visible region.

2. Organic light-emitting device (10) according to Claim 1, *characterized in* **that** it emits as the output a spectrum defined at 0° by its colorimetric coordinates (x2, y2) in the CIE XYZ 1931 chromaticity diagram, such that $\sqrt{((x1-x2)^2 + (y1-y2)^2)}$ is less than 0.1.

3. Organic light-emitting device (10) according to either of Claims 1 and 2, *characterized in that* it emits as the output a spectrum defined at 0° by its colorimetric coordinates (x2, y2) in the CIE XYZ 1931 chromaticity diagram and **in that** the path length, in the CIE XYZ 1931 chromaticity diagram, between the spectrum emitted at 0° and the spectrum emitted at 60°, is less than or equal to 0.1.

4. Organic light-emitting device (10) according to one of Claims 1 to 3, *characterized in that* the path length, in the CIE XYZ 1931 chromaticity diagram, between the spectrum emitted at 0° and the spectrum emitted at 60°, is less than or equal to 0.05.

5. Organic light-emitting device (10) according to one of Claims 1 to 4, *characterized in that* it forms one or more transparent and/or reflective luminous surfaces, especially an illuminating, decorative or architectural system, or an indicating display panel, for example of the drawing, logo or alpha-numeric indication type, the system producing uniform light or differentiated luminous zones, especially differentiated by guided light extraction in the glass substrate.

6. Organic light-emitting device (10) according to Claim 1, *characterized in that* L1 is less than or equal to 100 nm and/or L2 is less than or equal to 160 nm.

7. Organic light-emitting device (10) according to Claim 1, *characterized in that* L1 is less than or equal to 80 nm and/or L2 is less than or equal to 130 nm.

8. Organic light-emitting device (10) according to Claim 1, *characterized in that* L1 is less than L2.

9. Use of the organic light-emitting device (10) according to one of Claims 1 to 5:

  - for buildings, such as exterior luminous glazing, an internal luminous partition or a luminous glazed door (or part of a door), especially a sliding one;
  - for a transport vehicle, such as a luminous roof, a luminous side window (or part of a window), an internal luminous partition of a terrestrial, water-borne or airborne vehicle;
  - for urban or professional furniture, such as a bus shelter panel, a wall of a display counter or a shop window, a greenhouse wall, or an illuminating tile;
  - for interior furnishings, such as a shelf or cabinet element, a façade of a cabinet, an illuminating tile, a ceiling, an illuminating refrigerator shelf, an aquarium wall;
  - for the backlighting of electronic equipment, especially a display screen, optionally a double screen, such as a television or computer screen, a touch screen; and,
  - for an illuminating mirror, especially for lighting a bathroom wall or a kitchen work top, or for a ceiling.

Fig. 1

Fig. 2

Fig. 3

Fig. 4

## RÉFÉRENCES CITÉES DANS LA DESCRIPTION

**Documents brevets cités dans la description**

- US 20050073228 A1
- US 20050264185 A
- EP 1329307 A
- DE 19733053
- EP 1403939 A
- JP 11070610 B
- WO 04025334 A

**Littérature non-brevet citée dans la description**

- **C.H. JEONG.** four wavelength white organic light emitting diodes using 4, 4'- bis- [carbazoyl-(9)]- stilbene as a deep blue emissive layer. *Organics Electronics,* 2007, vol. 8, 683-689